(19) Europäisches Patentamt European Patent Office Office européen des brevets

(11) **EP 4 647 778 A1**

(12) **EUROPEAN PATENT APPLICATION**

(43) Date of publication:
**12.11.2025 Bulletin 2025/46**

(21) Application number: **24174398.8**

(22) Date of filing: **06.05.2024**

(51) International Patent Classification (IPC):
**G01R 15/20** (2006.01)

(52) Cooperative Patent Classification (CPC):
**G01R 15/207;** G01R 15/202

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Melexis Technologies SA
2022 Bevaix (CH)**

(72) Inventors:
• **Gallot, Mathieu
  92400 Courbevoie (FR)**
• **BOURY, Bruno
  3980 Tessenderlo (BE)**
• **HOUIS, Simon
  2022 Bevaix (CH)**
• **TOMBEZ, Lionel
  2022 Bevaix (CH)**

(74) Representative: **Winger
Mouterij 16 bus 101
3190 Boortmeerbeek (BE)**

(54) **CURRENT SENSOR AND IMC SYSTEM**

(57)     A magnetic field sensor is provided for sensing a current flowing in a first direction divided in at least two conductor portions separated in a second direction perpendicular to the first direction. It includes at least a first sensing element and second sensing element and at least one integrated magnetic concentrator for sensing the magnetic field at respectively first and second positions in a region between the two conductor portions. The sensing elements are adapted in combination with the concentrator to sense the field with a highest sensitivity in a sensing direction perpendicular to the first direction, wherein the two positions are separated by a predetermined distance in a spacing direction perpendicular to the sensing direction.

FIG. 1

EP 4 647 778 A1

## Description

### Field of the invention

The present invention relates to the field of magnetic field sensors for current measurement, and more specifically to a sensor configuration comprising magnetic concentrators for detecting magnetic fields associated with electrical currents in conductors.

### Background of the invention

The field of current sensing is an important component of modern electrical systems, particularly in the context of electrification and the increasing prevalence of electronic devices and electric vehicles. Current sensors are essential for monitoring and controlling the flow of electricity in circuits, ensuring safety, efficiency, and reliability in various applications ranging from industrial automation to consumer electronics.

The integration of current sensors into electrical systems often requires consideration of factors such as the sensor's footprint, mechanical robustness, and the response to magnetic noise. Magnetic shields are usually included at the sensing zone, to reduce the influence of magnetic noise in the sensor. However this requires the introduction of additional parts fixed to the assembly, which increases the footprint of the device.

Additionally, one of the broad problems faced in the field of current sensing is the accurate measurement of time-varying currents. As electrical systems become more complex and the demand for precise current measurement grows, the ability to accurately sense fast varying electrical currents, characterized by high rates of change over time (high di/dt), becomes increasingly important. High frequency currents is that they generate rapidly changing magnetic flux, which can induce unwanted voltages in nearby conductive elements. This phenomenon can lead to measurement errors and disturbances in the operation of current sensors. The induced voltages can interfere with the sensor's ability to accurately detect the actual current flowing through a conductor, resulting in inaccurate readings and potential malfunctions in the electrical system.

Despite the advancements in current sensing technology, there remains a need for further improvements, to address the challenges associated with measuring fast varying electrical currents and ensuring robust and accurate current sensing in a variety of applications.

### Summary of the invention

It is an object of embodiments of the present invention to provide a current sensor package with enhanced immunity to electromagnetic noise. This objective is accomplished by a magnetic field sensor according to the invention.

In a first aspect the present invention provides a magnetic field sensor as disclosed in the appended claims.

It is an advantage of embodiments of the present invention that external or stray magnetic fields can be compensated, without using large elements such as shields.

In some embodiments, the at least two sensing elements are separated in the second direction (X) being the direction perpendicular to the current through the conductor and parallel to the distance between the conductor portions of the hole where the sensor should be inserted. In some embodiments, the at least two sensing elements are separated in the third direction (Z) being parallel to the axis of the hole where the sensor should be inserted.

In some embodiments, the spacing direction of the two sensing positions is a first spacing direction perpendicular to the first direction (Y), and the sensor comprises at least two additional sensing elements for sensing the magnetic field at the two positions separated in a second spacing direction perpendicular to the first direction (Y) and different from the first spacing direction. It is an advantage of embodiments of the present invention that redundant signals can be used. It is a further advantage that error due to positioning can be compensated, thus increasing mechanical tolerances. It is an advantage that SNR can be improved.

In some embodiments, the additional sensing elements combined with magnetic concentrator have the highest sensitivity in a direction perpendicular to the second spacing direction. In particular, said direction perpendicular to the second spacing direction is the second direction (X) or the third direction (Z).

Thus, the pairs of sensing positions are separated or distanced in a direction perpendicular to the current, and each of the positions of a pair senses a magnetic field component being perpendicular to the separation direction and also perpendicular to to the current. The sensor may be adapted (e.g. with a processor) to provide a signal obtained from the measurement at each position of a pair.

In some embodiments, the sensor is configured to provide at least one gradient of one component in a direction different from the component direction, the direction of the gradient and of the component being in the plane perpendicular to the direction of the current which generates the field.

In some embodiments, the sensing element provides a signal corresponding to a magnetic field component or direction, wherein contributions from other components in different directions are negligible.

In some embodiments, the sensor comprises a substrate whereon the at least two sensing elements and the concentrator are provided, wherein the substrate lies in the plane comprising the second direction (X) and third direction (Z), wherein the sensing elements provide a signal each derived from a component of the field parallel to the substrate, the sensor further comprising a processing circuit arranged to obtain a sensor signal calculated as a difference or gradient of the signals from the sensing elements.

It is an advantage that the signal of the sensor can be provided by an easy calculation without requiring substantial processing power.

In some embodiments, the sensor comprises a package and conductive leads for interchanging signals between the exterior and the sensor, the conductive leads being elongated and extending from the package in the third direction.

It is an advantage of embodiments of the present invention that the coupling of magnetic fields with the signals from the sensor is reduced, thus improving electromagnetic compatibility even in the presence of high frequency currents or signals in the conductor.

In some embodiments, the elongated leads comprise a set of leads forming a single row aligned with the second directon (X).

It is an advantage of embodiments of the that the coupling of the current to be measured is further reduced. It is an advantage that that the leads do not form parasitic loops.

In some embodiments, each of the elongated leads carry either an analog signal or a digital signal, wherein the elongated lead extending away from the substrate comprise an end opposite to the substrate, wherein the leads carrying analog signal are configured for redirecting the signal and connecting to a first row of connections, and wherein the leads carrying a digital signal are configured for redirecting the signal and connecting to a second row of connections of a further device.

It is an advantage of embodiments of the that the coupling of the current to be measured is further reduced.

In some embodiments, all the leads of the sensor connect to the same side of the substrate. It is an advantage that all the leads extend away from the conductor carrying the current to be measured on the same side, for connecting to a single board for further processing of the signal and/or signal output.

In some embodiments, the at least one sensing element comprises at least two sensing elements combined with a magnetic concentrator per position.

In some embodiments, the at least one sensing element comprises at least two sensing elements per position combined with a magnetic concentrator per sensing element. In some embodiments, at least one sensing element is a horizontal Hall sensing element. In some embodiments, the sensing elements are disposed away from the geometrical center of the IMC, or even disposed close to the edges. In some embodiments, the concentrator is integrated on the substrate. In some embodiments, the concentrator is a thin structure extending the XZ plane.

It is an advantage that the sensing can be improved thanks to the in-plane magnetic gain provided by the magnetic concentrator in the elognated direction thereof. An advantage is that it provides magnetic gain in the sensing direction. In some embodiments, the aspect ratio of the concentrator is typically higher than 5, or 10. In some embodiments, the magnetic concentrator is made of magnetic material, e.g. soft magnetic material, e.g. FeNi.

The board, e.g. PCB may be disposed with its major surface parallel to the major surface of the current conductor.

In a further aspect, the present invention provides use of a sensor in accordance with any one of the previous claims for detecting high frequency currents through a conductor comprising a hole through the conductor in which the sensor is placed.

It is an advantage that accurate sensing can be obtained with good SNR and good rejection of stray or external fields, e.g. for a shieldless conductor.

In a further aspect, the present invention provides a sensing system comprising a conductor including a through hole surrounded by conductive material, further comprising a sensor in accordance with any one of embodiments of the first aspect, wherein the sensor is introduced inside the through hole so that the sensing elements are arranged to sense the field in at least two positions in a region between two conductive portions of the conductor.

**Brief description of the drawings**

Fig. 1 is a top view of a magnetic field sensor placed within a through-hole of a conductor, showing the sensing elements on a substrate and their separation in the second direction (X) according to embodiments of the present invention.

Fig. 2 is a lateral view of the magnetic field sensor and conductor, according to embodiments of the present invention.

Fig. 3 is a cross-sectional view of the conductor and magnetic field sensor, illustrating the connection of the sensor to a board via leads and the orientation of the sensing elements according to embodiments of the present invention.

Fig. 4 is a detailed view of the sensor wherein the sensing elements have their highest sensitivity axis not exactly parallel to the third direction (Z).

Fig. 5 is the lateral view of an alternative embodiment of a magnetic field sensor with the leads adapted to provide connection to a PCB in different rows of pads.

Fig. 6 is a schematic representation of a magnetic field sensor substrate with sensing elements and respective IMCs for sensing the field in two positions separated in the second direction (X) according to embodiments of the present invention.

Fig. 7 is a schematic representation of a magnetic field sensor substrate with two pairs of sensing elements for sensing the field in two positions separated in the second direction (X), each pair linked to an integrated magnetic concentrator (IMC) and each element of a pair separated in the third direction (Z) according to embodiments of the present invention.

Fig. 8 is a schematic representation of a magnetic field sensor substrate with two pairs of sensing elements, each element of a pair separated in the third direction (Z) and linked to a respective IMC, with the pairs separated in the second direction (X) according to embodiments of the present invention.

Fig. 9 is a similar view as Fig. 3 and Fig. 4 of a magnetic field sensor with four sensing positions, two separated in the third direction (Z) and two more distanced in the second direction (X) according to embodiments of the present invention.

Fig. 10 is a detailed view of a magnetic field sensor substrate, showing pairs of Hall elements combined with an IMC in a gradiometric configuration for each sensing position according to embodiments of the present invention.

Fig. 11 is a schematic representation of a magnetic field sensor substrate with four pairs of horizontal Hall elements, two pairs separated in the third direction (Z) and two additional pairs distanced in the second direction (X) according to embodiments of the present invention.

Fig. 12 is a schematic representation of a magnetic field sensor substrate similar to Fig.10, with four IMCs functionally linked to Hall elements of different pairs according to embodiments of the present invention.

Fig. 13 is a perspective detail of a circular IMC oriented perpendicular to the first direction, for use in a sensor in accordance with embodiments of the present invention.

In the different figures, the same reference signs refer to the same or analogous elements.

## Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top and over and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", also used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be interpreted as being limited to devices consisting only of components A and B. It means that with respect to the present invention, the only relevant components of the device are A and B. The term "comprising" therefore covers the situation where only the stated features are present and the situation where these features and one or more other features are present. The word "comprising" according to the invention therefore also includes as one embodiment that no further components are present. When the word "comprising" is used to describe an embodiment in this application, it is to be understood that an alternative version of the same embodiment, wherein the term "comprising" is replaced by "consisting of", is also encompassed within the scope of the present invention.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

As used herein, and unless otherwise specified, the term "magnetic field sensor for sensing a current flowing in a first direction (Y)" refers to a device or component designed to detect the presence and characteristics of a magnetic field generated by an electrical current that flows primarily along a specified direction, which is parallel to an axis designated as the Y-axis. The present invention provides a magnetic field sensor (e.g. Hall effect-based sensor) in combination with a magnetic concentrator, usually integrated on the same substrate whereon the Hall-effect sensing elements are provided. In some embodiments, the sensing elements may be magnetoresistive sensing elements (TMR, AMR and such), and fluxgate-based sensors, the present sensor not being limited thereto. Such sensors can detect magnetic fields resulting from direct current (DC), alternating current (AC), or pulsed current flow.

As used herein, and unless otherwise specified, the term "at least two conductor portions separated in a second direction (X)" refers to segments or parts of an electrical conductor that are physically distinct and spaced apart along an axis or line designated as the X-axis, which is orthogonal to the Y-axis. This can include, for example, two separate wires, traces on a printed circuit board, or sections of a conductive path that are designed to carry an electrical current. It is noted that the conductor portions generate a magnetic field from the current flowing in the first direction. The first direction, thus, is the direction of the current that generates the detected field. This direction may be the same as the current direction throughout the rest of the conductor, but it is not essential (e.g. the portions may redirect the current locally around the hole where the sensor is placed).

As used herein, and unless otherwise specified, the term "at least two sensing elements for sensing the magnetic field at two positions in a region between the two conductor portions" refers to components within the magnetic field sensor that are capable of detecting the magnetic field and are positioned at two distinct locations within a region defined by the boundaries between the two separated conductor portions. For example, the sensing elements may be confined to the projection of the hole in the XY plane (e.g. the top view), although one or both sensing positions may be outside the hole, on each side of the conductor. In some embodiments, the sensing elements may be confined within the hole, thus in the projection of the hole in the XY plane and in the XZ plane.

These sensing elements can be Hall effect sensing elements, which combined with IMCs can detect the field at a specific position, and in particular at least one specific component of the field at that position. The term "horizontal Hall elements" refers to Hall effect sensors that are oriented such that their active sensing area lies in a horizontal plane when the sensor is positioned in its intended operational orientation. These elements can detect magnetic field components that are perpendicular to their active sensing area. The IMCs allow redirecting the field so that the Hall element senses a predetermined component of said field.

As used herein, and unless otherwise specified, the term "substrate" refers to a base material or layer upon which the sensing elements and possibly other components of the sensor are mounted or fabricated. This substrate can be made of materials such as semiconductor (SC) such as silicon, ceramics, glass, polymer, or any suitable insulating or semiconducting material that provides mechanical support and possibly electrical insulation for the components. The substrate may be a leadframe. The sensing elements could be disposed adjacent to the SC die, on the leadframe, and electrically connected to the SC die.

As used herein, and unless otherwise specified, the term "processing circuit" refers to an electronic circuit or system that is capable of receiving signals from the sensing elements, performing calculations or operations on these signals, and outputting a resultant sensor signal. This processing circuit can include analog or digital components such as amplifiers, filters, analog-to-digital converters, microprocessors, or any combination thereof. The processing circuit can be provided in the substrate. For example, the substrate can be implemented as a CMOS integrated circuit. The processing circuit may be programmed to provide a readable signal to an output based on the signal generated by the sensing elements.

As used herein, and unless otherwise specified, the term "magnetic concentrators" refers to materials or structures that are incorporated into the sensor with the purpose of enhancing the magnetic field in the vicinity of the sensing elements. These concentrators can be made of high-permeability materials such as ferrite or permalloy and are designed to focus or channel the magnetic field lines to increase the sensor's sensitivity and accuracy. They can be integrated in the substrate with the sensing elements, e.g. integrated in the semiconductor (SC) substrate, so in the present disclosure they are referred to as integrated magnetic concentrators (IMC), the present invention not being limited to concentrators integrated in the SC chip. The soft magnetic material may be for example FeNi.

The IMC can be integrated on the substrate, but it can also be integrated in the substrate, or at least partially in the substrate. For exemple the IMC can be integrated on an integrated circuit (IC) or at least partially in the integrated circuit, rather than inside the package but not on/in the IC.

As used herein, and unless otherwise specified, the term "conductive leads" or simply "leads" refers to elongated conductive paths or wires that are used to transmit electrical signals provided by sensor to external devices or systems. These leads can be made of metals such as copper, aluminum, gold, or any other conductive material suitable for carrying electrical signals.

As used herein, and unless otherwise specified, the term "packaged sensor" refers to a magnetic field sensor that has been enclosed or encapsulated in a protective housing or package, which can provide mechanical protection, environmental isolation, and possibly electrical connections to external circuits. This packaging can be made of materials such as plastic, ceramic, or metal and can be designed to meet specific standards for durability, thermal management, and electrical performance.

As used herein, and unless otherwise specified, the term "use of a sensor for detecting high frequency currents" refers to the application or employment of the magnetic field sensor in a manner that enables the detection and measurement of electrical currents that alternate or change direction at high frequencies, which can range from thousands to millions of cycles per second (kilohertz to megahertz). This includes using the sensor in various industrial, automotive, or research settings where monitoring of high-speed electrical signals or power distribution is required.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

The present invention relates to a current sensor and sensing system based on magnetic field detection and monitoring. A magnetic sensor picks the magnetic field near a conductor, and the value of the field is used to measure the electrical current through the conductor, which is the intended source of the field. Since other sources of magnetic field may be present (e.g. nearby electrical devices, noise and other electromagnetic interferences, etc.), it is usual that existing sensing systems include a shield around the sensor, to block these parasitic contributions. The shield usually comprises one or more ferromagnetic plates. The present invention does not require such shield or, if present, allows to reduce the dimensions of such a shield, reducing material and allowing more compact implementation. This is provided by the specific layout and signal processing enabled by the sensor.

The sensor is adapted to be introduced into a through-hole in a conductor. The current through the conductor portions at the sides of the sensor follows a first direction Y, the second direction X is perpendicular to the first direction Y and to the direction of the hole, which follows the third direction Z. In general, the second direction X is the direction of separation between the two conductor portions.

The sensor includes sensing elements combined with IMCs to provide sensing at a plurality of sensing positions. The sensing elements can include Hall-effect sensing elements, which are sensitive to fields crossing them. When combined with IMCs, they are adapted to sense the field at the sensing position with the highest sensitivity in a general direction perpendicular to the current direction. Although the disclosure is focused on Hall elements combined with IMCs, the sensing elements may be different, as indicated above. The sensors are separated in a direction perpendicular to the current direction and also perpendicular to the direction of highest sensitivity. For example, if the component Bz is sensed at the sensing positions, the sensing positions are separated in the second direction (X) perpendicular to the axis of the hole. The sensing positions are disposed in the X-Z plane.

In the following, the description relates to a sensor wherein the sensing positions form at least one pair distanced in a given direction within the plane perpendicular to the current generating the field, wherein the component sensed is perpendicular to the distancing direction. The sensed component at the sensing position has a direction perpendicular to the distancing direction. When additional sensing elements are present, each pair senses a field component perpendicular to the respective direction on which the elements of the pair are distanced from each other.

The sensor is configured (for example, by appropriate connections, by processing, etc.) to provide a gradient of a component of the field, wherein the direction of the gradient is perpendicular to the direction of the component, both the component and the distancing direction being in the same plane, perpendicular to the current that generates the field.

In embodiments, only the field component with the direction perpendicular to the spacing direction is actually sensed. In case additional sensing elements are present, each pair of sensing elements can sense the field only in a direction perpendicular to the respective spacing directions. In other words, the sensing elements are adapted so that the contribution to the signal from other components of the field is negligible.

In some embodiments, the sensing positions are distanced within the hole in the second direction X, and the direction of the field sensed at the sensing positions follows the direction of the hole (the third direction). However, the disclosure is also valid for sensors with sensing positions being separate in the third direction Z following the hole axis, where the measured field component is perpendicular to the axis and to the current, Bx. Additionally, combination of both configurations may be present in the same sensor, for improving sensing.

Although the following description relates to measurement of the field in the direction of the hole axis, the direction does not need to be exactly parallel to the direction of the hole axis, but it can have a directional tolerance. The highest sensitivity may be +/- 70 degrees from the direction of the axis of the hole (Z). Preferably, the highest sensitivity follows the third direction Z since the symmetry is higher and there is less need to process the signal to enhance noise cancellation. In embodiments of the present invention, the direction is defined within the XZ plane so the component of the highest sensitivity of the sensor in the first direction Y is negligible.

The parasitic contribution from external stray fields on the magnetic field generated by the current conductor is cancelled due to the configuration of the sensing elements. For example, the sensor measures dBz/dx. This can be obtained by measuring the field Bz1 at a first position and the field Bz2 at a second position. Then the difference, i.e. Bz1-Bz2, is obtained, either from the analog signal or from the digital signal. Thus, contributions of e.g. constant external stray field at the two positions cancel each other.

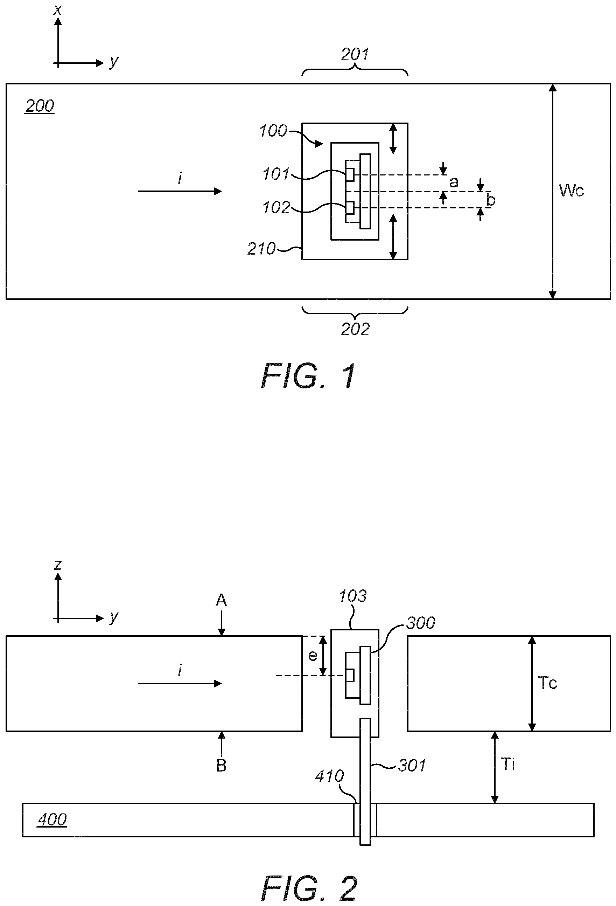

Fig. 1 shows the top view of a sensor 100 surrounded by two conductor portions 201, 202, e.g. inside a through-hole 210 provided on a conductor 200, where the conductor in this example is a flat conductor, such as a bus bar. It has a width Wc and extends in a longitudinal direction, which is in this example the direction of the current flow. The longitudinal direction and width correspond to the first and second direction of the plane XY (the first direction being the direction Y in the figure). In some embodiments, the hole is centered so the conductor portions surrounding the sensor have the same width, so the system has symmetry. However the hole may not be exactly centered; for example a correction factor may be applied in these cases. The figure shows the at least two sensing elements 101, 102 on a substrate 300, which may be a planar substrate, for example a SC substrate. They are separated by a distance e in the third direction Z perpendicular to the first direction Y and second direction X. The sensing elements sense the field in two positions within the hole, which means that both positions are at a predetermined distance a, b of the central axis of the hole). In some embodiments the positions are at the same distance from the axis, for example a = b.

Fig. 2 shows a lateral view of the previous conductor and sensor. The thickness Tc of the bus bar is shown. The sensing positions are at a predetermined distance e from the closest surface A of the conductor. Since it is advantageous that the positions are symmetrical, the sensing positions may be at the center of the hole (so they are equidistant from both surfaces A, B of the conductor The sensor may be a packaged sensor, so the substrate and optionally the sensing elements may be covered by a package 103. The sensor package may be longer than the hole, so it may stick out of the hole through one or both sides of the hole (as shown in the figure), or the package may be completely inside the hole.

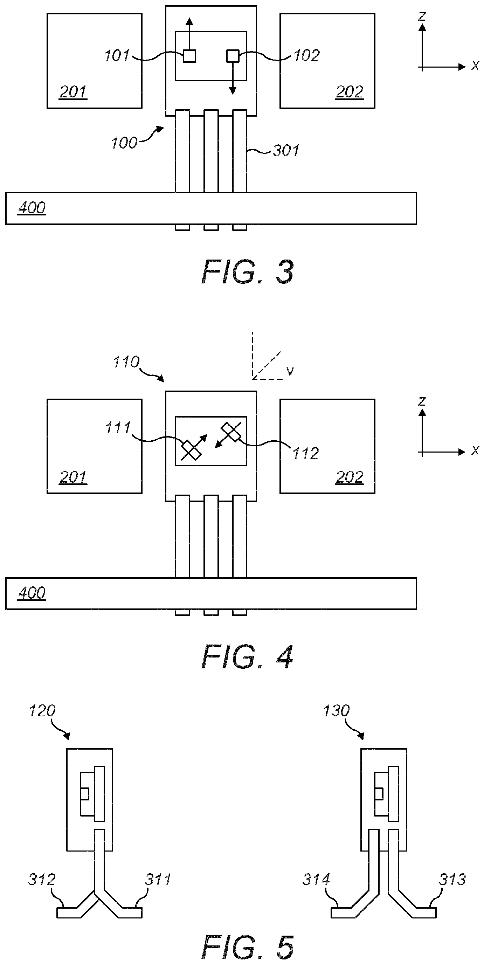

The sensor may include pins or leads 301 to connect to a board 400, e.g. a PCB, to interchange signals with the exterior. The PCB 400 may be separated from the conductor 200 by a predetermined distance Ti, for example between 0.5 mm and 4 mm; in the embodiment of the figure, the conductor and the PCB are parallel. For example, the PCB may be disposed with its major surface parallel to the major surface of the current conductor (e.g. bus bar). The leads 301 extend towards the PCB (e.g. in the third direction Z). They may extend from the same side of the sensor. For instance, the leads may be provided only on one side of the package. The leads connect to a row of connections 410 provided on the PCB, however the present invention is not limited thereto, as shown in Fig. 5 below. Some of the leads are adapted to connect to different areas of the board, the areas comprising e.g. contacts or the like, separated in the Y direction. In some embodiments, the leads provide flexibility for height selection relative to the PCB (and to the height of the sensing positions in the hole of the conductor). These height can be controlled using protrusions (for example, stamped pins).

The elongated leads 301 may comprise a set of leads forming a single row aligned with the second direction (X) forming a configuration where the conductive leads are arranged in a linear array or sequence that extends along the X-axis, facilitating organized connections and possibly simplifying the layout of the sensor within a system. Since they extend perpendicularly relative to the current and perpendicularly to the second direction X, leads are arranged to prevent the formation of parasitic loops, thus eliminating induced voltages from varying magnetic flux, in particular induced by fast current variations in the conductor. This allows the use of a sensor for detecting high frequency currents with high accuracy, since parasitic loops of the magnetic field on the leads are reduced or avoided. In some embodiments, the leads 301 form a row in the second direction X, as shown in Fig. 3.

Thanks to the arrangement of the leads in the mechanical coupling between the sensor and the PCB, for example relative to the current, improves the performance of the sensor and its immunity to fast current transients. The flux is reduced or null since the leads do not form parasitic loops; (dphi/dt)=0

More in detail, Fig. 3 is a cross section view of the conductor, its hole and sensor 100 which shows the front of the sensor facing the sensing elements. The sensor 100 connected to the board 400 via leads 301. The arrows at the sensing positions indicate the direction of the magnetic field detected ; the magnetic field has opposite directions at the two positions due to symmetry. The axis of detection, correspondign to the direction of highest sensitivity of the respective sensing element, may point in the same direction. They are defined in the same, third, direction Z. The gradiometric (or differential) configuration of the sensor allows providing an output signal by combination of the signals of the sensing elements. In any case, either by analogous or digital processing of the sensing element signals, the output signal provided by the sensor results from the gradient or the difference, e.g. dBz/dx or Bz1-Bz2, of the signals measured by the sensing elements. In Fig. 3, the direction of highest sensitivity follows the third direction Z. However the present invention is not limited thereto. Fig. 4 shows an example of sensor 110 with sensing elements 111, 112 such that that the direction of highest sensitivity does not match exactly the third direction Z, forming an angle v between +/- 70 degrees angle with the third direction Z, e.g. around 45 degrees. In this configuration, which is also a gradiometric configuration, the field may be detected at 45 degrees relative to the third direction Z. An advantageous embodiment, due to the higher symmetry, is the one in Fig. 3, wherein the angle is 90 degrees. In some embodiments each element has the direction of highest sensitivity with different orientation, e.g. opposite orientation as shown in the figures, so the signal can be easily processed to obtain the final reading. However, as before, they may have the same orientation also.

In some embodiments, the sensing positions and/or the sensing elements are located away from the center of the substrate. For example these may be close or adjacent an edge of the substrate such as a semiconductor substrate. For example, the sensing elements may be located at a distance smaller or equal to 10%, or 15%, or 20% of the width 'ws' of the substrate, measured from the edge of the substrate, e.g. the closest edge.

In some embodiments, the sensing positions allow to increase the distance between the sensing elements, improving sensing within the hole.

In some embodiments, as shown in Fig. 3 or Fig. 4, the area of the major surface of the SC substrate 300 is smaller than the area of the cross section of at least one of the conductor portions 201, 202 (or both). Additionally for the same cross section, the area of the package 103 may be larger than the area of the cross section of the conductor portion.

Fig. 5 shows a side view of two alternative sensors 120, 130 with leads 311, 312, 313, 314 adapted to connect to multiple rows of pads in a board. In the exemplary embodiment at the left, the leads 311, 312 of a sensor 120 extend from a single row. The end opposite to the substrate of some leads is adapted to connect to a first row of pads, while the end of others may be adapted to connect to a different row of pads. For example, optionally the ends may be bent, or may be extended with feet as shown in the figure. In some embodiments, the exemplary embodiment at the right, the leads 313, 314 of a sensor 130 form two rows. The ends may be also optionally bent, the present invention not being limited thereto. For example, contact may be made by press-fit connectors. In some embodiments, the pads of a row interchange digital signal while the pads of a different row interchange analog signals. Thus, the leads adapted to contact the same row carry the same type of signals (e.g. digital or analog). Since the signals are separate, there is no loop among the analog pads, and not loop among the digital pads. The contribution of dI/dt is reduced or even cancelled in each domain. The only remaining parasitic loop is formed between the two domains, which has a relatively low impact on the sensor operation. Thus, the SNR is increased.

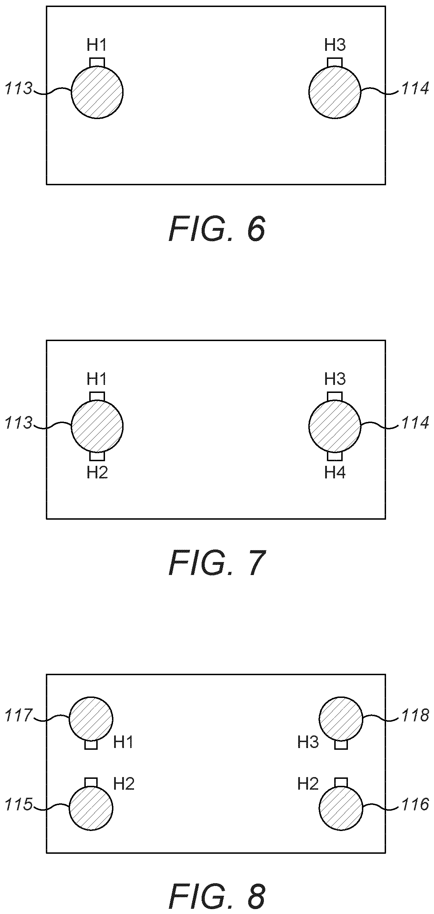

Fig. 6 to Fig. 8 show three different distributions of sensing elements in sensors of the present invention. The signal from the sensing elements is processed to provide the measurement from the current through the conductor, while cancelling noise contributions. The sensor output is proportional to dBz/dx, for example the output of the sensor is equal to k. dBz/dx, where k is a predetermined calibration factor. The magnetic field is sensed in two positions distanced in the second direction (X), disposed on a major surface of the substrate in the X-Z plane. For example, dBz/dx can be obtained by the difference of the field at the two sensing locations, i.e. Bz1-Bz2. Hall elements are used combined in different configurations with IMCs for sensing the field at these positions in the required directions., in particular horizontal Hall elements having an axis of maximum sensitivity perpendicular to the substrate, in other words, following the first direction Y since they are perpendicular to the substrate which extends in the plane XZ. Thanks to the IMC, they can measure different components of the field. The elements are designated by H1, H2...

Fig. 6 shows a sensing position in each of 2 positions distanced in the second direction X in a gradiometer configuration. The disposition of the IMCs 113, 114 relative to the respective sensing elements H1, H3 is such that the axis of the magnetic field detected by the sensing elements is rotated around the X direction. In other words, when an IMC is combined with an horizontal Hall element, the IMC redirects the field so the element detects both Bx and By (as the axis of maximum sensitivity of plate and IMC is at 45 degrees). When a difference is taken, only the differential field remains. Thus, the difference of the responses of each element H1-H3 is proprotional to dBz/dx (both common modes Bz and By being cancelled out).

Fig. 7 shows two pairs of sensing elements, a first pair H1, H2 linked to an first IMC 113 and a second pair H3, H4 linked to a second IMC 114. The elements of each pair are distanced in the third direction Z in opposite sides of its respective IMC. The pairs at the sensing positions (and corresponding IMCs) are distanced in the second direction X following the axis of the through-hole. The left pair of sensing elements H1, H2 around its IMC 113 can be used to provide a sensing signal Bz1 at that first position (e.g. as H1-H2). The right pair H3, H4 provides a second sensing signal Bz2 at the second position (e.g. as H3-H4). Both signals are representative of the component of the field in the third direction Z. As in the previous figure, the signal dBz/dxcan be obtained (e.g. difference of the output of the top and bottom pairs, e.g. (H1-H2)-(H3-H4)).

Fig. 8 shows an analogous distribution as in Fig. 7, however instead of one IMC per pair of sensing elements, each sensing element is associated with an IMC. In detail, two pairs of sensing elements are provided, the elements H1, H2 of the left pair being distanced from the other in the third direction Z, each element H1, H2 being linked to a respective IMC 115, 117 disposed so that the component in the third direction Z of the magnetic field is measured, and the elements H3, H4 also disposed in the same way next to a respective IMC 116, 118. The two pairs are thus arranged to measure said component (Bz) of the field, at each of two positions, being separated in the second direction X. In this example, each pairs of sensing elements (i.e. H1 and H2, and H3 and H4) may be disposed adjacent to one another, for example directly next to one another.

The following is an exemplary signal processing for the embodiment of Fig. 6 (one horizontal Hall element, HH, and one IMC per sensing spot):

$$H1 = gz.Bzext + gy.Byext + gz.Bz\_i$$

$$H3 = gz.Bzext + gy.Byext - gz.Bz\_i$$

$$S = H1 - H3 = 2.gz.Bz\_i \ (=dBz/dx)$$

The following is an exemplary signal processing for the embodiments of Fig. 7 and of Fig. 8 (two HH, and one or two IMC per sensing spot):

$$H1 = gz.Bzext + gy.Byext + gz.Bz\_i$$

$$H2 = -gz.Bzext + gy.Byext - gz.Bz\_i$$

$$H3 = gz.Bzext + gy.Byext - gz.Bz\_i$$

$$H4 = -gz.Bzext + gy.Byext + gz.Bx\_i$$

$$S = (H1-H2) - (H3-H4) = (2.gz.Bzext + 2gz.Bz\_i) - (2.gz.Bzext - 2.gz.Bz\_i) = 4.gz.Bz\_i \ (dBz/dx)$$

The factors gz, gy are proportionality or signal conversion factors (e.g. including magnetic gain provided by the IMCs). Bzext and Byext are the noise contributions. It is noted that the contribution Bxext of the noise to the magnetic field in the second direction (X) is negligible, since it is considered that the structures are well aligned, so the component of the field in the second direction (X) is unaffected at the sensing position. For example, the component in the second direction (X) may be perpendicular to the axis of sensitivity of the sensing element itself in case of horizontal Hall elements, so such component is not detected. However, even if there is a residual contribution to the signal, the combination would result in a cancellation of the noise contribution of the magnetic component in the second direction (X). Bz_i is the contribution from the current. The sign of the contribution from the current stems from the fact that the sensing elements sense the field from a current at each portion 201, 202 of the conductor, since the magnetic field contribution generated by each conductor portions at each of the sensor positions have opposite signs.

The sensor configurations can vary from single pairs of sensing elements to multiple pairs in gradiometric arrangements. The additional signals can be used for redundancy, or SNR improvement, or reduction of error due to mechanical tolerances. Different configurations are shown in the following figures.

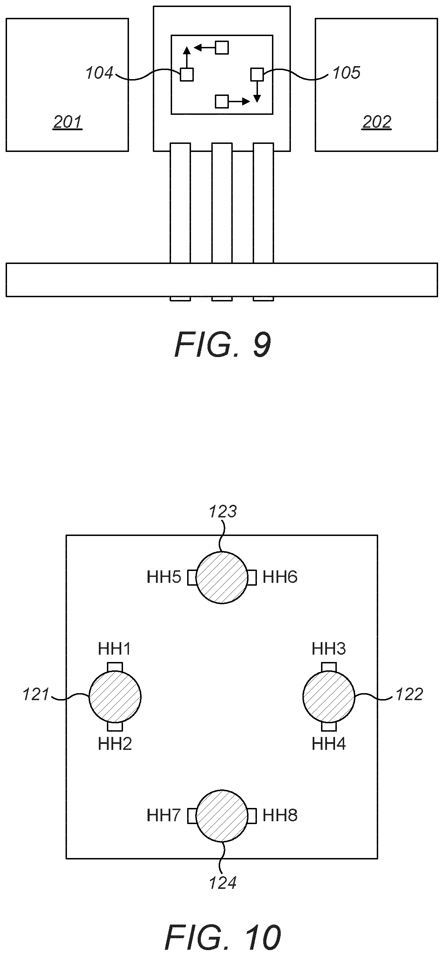

Fig. 9 and Fig. 10 show examples with four sensing positions, two separated in the third direction Z, and two more distanced in the second direction X.

The schematic cross section of Fig. 9 shows the conductor and sensor connected to the board as in Fig. 3. The sensor in Fig. 9 shows the four positions of measurement. The sensing elements at closest to the orifices of the through-hole provide the signal S1 from the two sensing positions as in e.g. Fig. 3. Another set of sensing elements 104, 105 are provided closest to the conductor portions, preferably in the hole, and distanced in the second direction (X). The direction of maximum sensitivity is indicated, as in Fig. 3. by the arrows.

The top and bottom sensing positions are used to obtain a first signal S2 and the right and left sensing positions provide a second signal S1, thus:

$$S1 = Bz1 - Bz2$$

$$S2 = Bx1 - Bx2$$

The signals S1 and S2 can be seen also as a gradient dBz/dx, dBx/dz respectively

Fig. 10 shows in detail the sensing elements on the substrate, where a pair of Hall elements, for each sensing position, are combined with one IMC per pair. The difference of the signals obtained by opposite pairs of sensing elements (corresponding to opposite IMCs) provide a first and second signals S1, S2 as explained earlier. In particular, the top pair of sensing elements HH5, HH6, respectively bottom pair HH7, HH8 are separated by a top IMC 123 and bottom IMC 124, each pair providing respectively the sensing element signals Bz1 and Bz2 from which the first signal S1 is obtained. The same applies to the left pair and right pair, whose IMCs 121, 122 are distanced in the second direction X. The sensing elements and the IMC may be configured relative to each other so the direction of highest sensitivity is provided in the directions as specified in Fig. 9. For example, the horizontal Hall elements HH5, HH6, HH7, HH8 may be disposed opposite to each other in each pair in the second direction X for the top and bottom pairs, and additional Hall elements HH1, HH2, HH3, HH4 of each pair may be distanced in the third direction Z with the respective IMC 123, 124 inbetween.

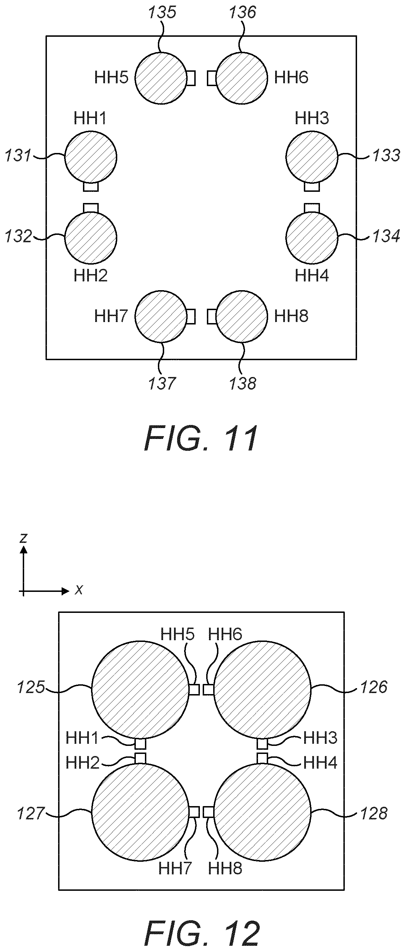

Fig. 11 and Fig. 12 show another two substrates for use in embodiments of the present invention, using four pairs of horizontal Hall elements. Two pairs of horizontal Hall elements are positioned on top and bottom positions (the pairs being distanced in the third direction Z), the Hall elements being configured so that the sensibility follows the second direction X. Two further pairs are distanced in the second direction X, centered relative to the distance between the top and bottom element.

Fig. 11 shows an embodiment wherein each Hall element HH1, HH2, ... HH8 is linked to an IMC 131, 132, ... 138. This embodiment is similar to the one shown in Fig. 10, only adding two more pairs in for sensing the field in two positions, with the direction of highest sensitivity being the third direction Z.

The components are obtained from the signals of the sensing elements, for the embodiment of Fig. 11 (also applicable to the embodiment of Fig. 10).

$$Bz1 = HH1 - HH2$$

$$Bz2 = HH3 - HH4$$

$$Bx1 = HH5 - HH6$$

$$Bx2 = HH7 - HH8$$

Alternatively, one IMC can be used in more than one position to provide high sensitivity in different directions, e.g. in perpendicular directions X, Z. For example, Fig. 12 shows an embodiment similar to the one in Fig. 11, where the gradiometric configuration and signal treatment is similar to that in Fig. 11, to obtain each of two signals. However as shown in Fig. 12, four IMCs are provided, and each IMC is linked functionally with a Hall element in a different pair. In the particular example of Fig. 12, one of the Hall elements of the top or bottom pair shares an IMC with a Hall element of the right pair or left pair of elements.

The components are obtained from the signals of the sensing elements, for the embodiment of Fig.12, as in the embodiment of Fig. 11.

The embodiments showing two pair of sensing positions separated in the second direction (X) respectively in the third direction (Z) provide a signal per pair of sensing positions, S1 and S2. As mentioned earlier, the signals can be used for increased SNR or increased resilience to mechanical misalignments, for example by combining both signals S1, S2. These signals additionally or alternatively can be used for increased safety, for example by comparing the signals, for detecting e.g. irregularities or increase in noise. In some embodiments, the signals can be additionally or alternatively output separately.

Regarding Figs. 9-12, it is noted that the spacing between the elements of the one pair can be equal to the spacing between the elements of the other pair. Alternatively, the spacing may be different for different pairs. For example, the spacing between the elements separated in the third direction Z can be lower than the spacing between the elements separated in the second direction X, or vice versa. An advantage is to optimize the sensed signals as a function of the though-hole dimensions.

In the figures, circular IMC are shown, however different shapes (e.g. elongated shapes) may be used for the IMC. The inventors found out that the configuration of the present invention provides reliable reading of even high frequency currents, despite using IMCs which introduce magnetic non-idealities (such as hystheresis and saturation) . Sensing in the XZ plane allows that the influence of parasitic loops becomes negligible, and if IMCs are provided, the sensing is improved thanks to the in-plane magnetic gain provided by the IMC in the elognated direction thereof.

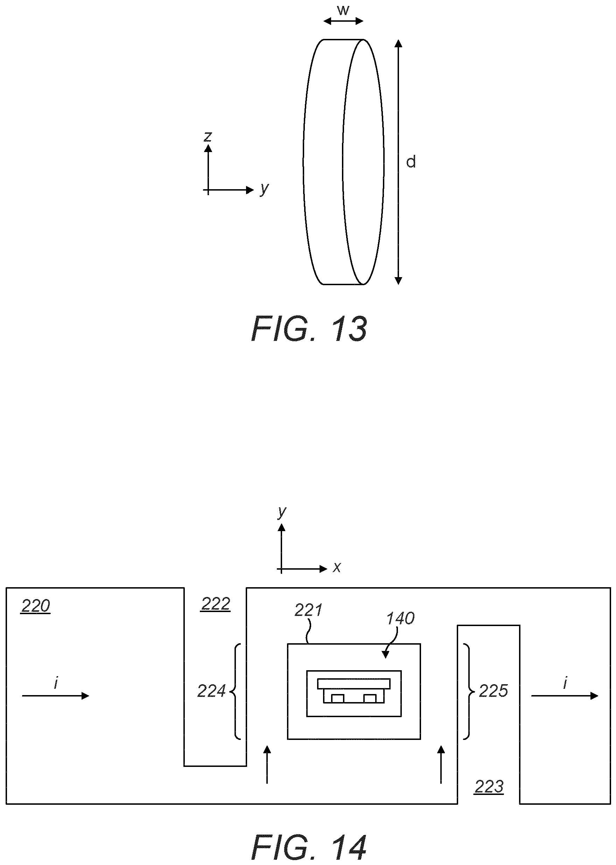

Fig. 13 shows an exemplary IMC where the largest surface is the plane perpendicular to the current. The IMC may be a circular plate of diameter d and thickness w, where the thickness is much smaller than the diameter. For example the aspect ratio is higher than 5, e.g. or 10. Other shapes may be used. The aspect ratio of the IMC (thin and elongated in the XZ plane) provides magnetic gain in the XZ plane. The IMC may be provided on the substrate by known techniques, such as deposition techniques (including electroplating or sputtering).

The sensor in embodiments of the present invention may comprise a packaged integrated circuit IC (e.g. a CMOS IC), including sensing elements which can sense a component in the direction parallel to the axis of the hole (third direction Z). The sensing elements and IMCs are disposed so the field is sensed in different positions, distanced in the same direction as the conductor portions. The signal is obtained as the gradient or difference of the signals provided by each sensing element. The sensing elements are disposed along the substrate, which may be an SC substrate, on the XZ plane. It may be an IC with sensing elements, the IC comprising for example a processor for processing the signals provided by the sensing elements The IC may be molded, forming a current sensor package capable of accurately measuring time-varying currents with high di/dt, while minimizing the effects of spurious induced voltages due to varying magnetic flux. Such sensor has improved reliability and accuracy of current sensing in applications driven by electrification, such as electric vehicles and renewable energy systems.

In some embodiments, the sensor is designed to sense two in-plane magnetic field components and compute a gradient or difference, with the processing circuit outputting a signal indicative of the current based on the magnetic field gradient or difference. Leads are used to interchange signals between the exterior and the sensor, for example leads arranged to minimize current loops. Press-fit connections can be used to attach the sensor to a board for output of the sensor signal.

The sensor package measures the magnetic field gradient within the through-hole of the conductor, translating this into a current measurement with improved immunity to fast transients (di/dt). The use of elongated leads and the specific arrangement of the sensing elements minimizes the induction of spurious voltages. The redundancy provided by multiple gradiometers improves the signal-to-noise ratio and reduces errors due to mechanical tolerances.

The current sensor package provides enhanced immunity to fast current transients, capable of accurately measuring high currents with high frequency with reduction of induced voltage errors. The sensor can advantageously be used for applications requiring precise current measurements in environments with strong magnetic interference.

The sensor in embodiments of the present invention measures the variation of a component in a plane, the plane of the substrate where the sensing elements are provided, by providing measurement of a component of the field in to positions and compute their difference or gradient, resulting in a signal indicative of the current flowing in the conductor. The sensor package performs reliably in real-world applications, such as in electric vehicles or renewable energy systems, where fast transient detection is crucial. The elongated leads are configured to reduce or prevent parasitic induction. The redundancy provided by multiple gradiometers enhances the signal-to-noise ratio and reduces measurement errors due to mechanical tolerances.

In a second aspect, the present invention provides a sensing system comprising a sensor in accordance with embodiments of the first aspect of the present invention. The sensing system comprises an assembly or arrangement that includes both a conductor with specific features, such as a through hole, and the magnetic field sensor as described in the first aspect of the invention. Preferably, the through-hole is centered so that the same thickness of conductor is left on each side of the hole, the present invention not being limited thereto.

This system is designed to measure or monitor the magnetic field generated by electrical currents flowing through the conductor, with the sensor being positioned in a strategic location relative to the conductor to achieve the desired sensing performance. The sensor may be a packaged integrated circuit (IC) with at least two magnetic sensing elements, and a processing circuit. The IC is positioned between the two conductor potions, inside the through-hole, with the sensing positions spaced apart in the second direction X.

The IC surface is perpendicular to the current flow in the XZ plane. It is noted that the direction of the current refers to the direction of the current through the portions delimiting the hole. This direction can be parallel to the longitudinal axis of the conductor as shown in Fig. 1. However, in some embodiments, the current from the conductor can 'redirected' in a direction different from the longitunal axis of the conductor. The embodiment in Fig. 14 shows a conductor 220 and a hole 221 wherein the sensor 140 is included. Two grooves 222, 223 are open at opposite sides of the conductor, at the left and the right side of the hole in the conductor. The direction of the conductor portions 224, 225 are in this embodiment defined by the grooves and the hole. Thus, the current 'i' traverses the groove and is redirected. In this case, the first direction (Y) is defined by the current in the portions, which is the direction perpendicular to the longitudinal axis of the conductor (and perpendicular to the direction of the hole as before). Analogously, the second direction X is defined by the separation between conductor portions 224, 225 as before.

The orientation of the sensor 140 is done as before, with the sensing positions distanced in the second direction (X), thus in the direction between the conductor portions, and preferably in the plane perpendicular to the first direction (Y). Said first direction (Y) is the direction of the current through the conductor portions which, in the embodiment of Fig. 14, is perpendicular to the longitudinal axis of the conductor. For embodiments of the sensor including Hall elements and IMCs, the previous explaination regarding directions of highest sensitivity still applies, however taking into account the definition of the first direction (Y) as shown in Fig. 14.

A printed circuit board (PCB) can be used to extract the signal form the sensor, with its major surface parallel to the axis of the current conductor. In embodiments wherein the conductor comprises a flat surface (e.g. in the case of a bus bar), the PCB major surface may be parallel to the major surface of the current conductor. In some embodiments, an isolation region, such as air or plastic, can be maintained between the PCB 400 and the conductor 200, in the space left therebetween Ti (see e.g. Fig. 2). The moulded portion of the current sensor, including the IC, is at least partially inside the hole and electrically and mechanically coupled to the PCB by a plurality of elongated leads.

In general the present invention provides a magnetic field sensor for sensing a current through a conductor. The current is divided in two conductor portions separated by a gap wherein the sensor is placed. The invention allows reducing noise by orienting the different parts of the sensor relative to each other appropriately, for example by orienting the sensing positions so that the sensor has a gradiometric configuration.

For example, the sensor comprises at least two sensing elements for sensing the magnetic field at two positions in a region between the two conductor portions. They are laid out in a plane perpendicular to the direction of the current. Their highest sensitivity is approximately pointing in the direction of the axis of the hole, although they can be in any a direction within a range of +/- 70 degrees from the axis of the hole. The sensing positions are both coplanar and separate in a direction parallel to the direction on separation of the conductors.

The sensor is provided as a packaged chip with leads extending away from the sensing positions from one side of the package, for connecting to a board which may extend parallel to the conductor. The package may be known from the art, however the leads may extend coplanar to each other, forming one or two rows. As explained with reference to Fig. 5, specifically the embodiment on the right, the leads may extend in two rows towards the substrate, or they may extend as a single row. Advantageously, such configuration provides leads that carry signals. These are barely affected, or not affected at all, by the current through the target conductor (even if carrying high frequency current) thanks to the relative orientation of the leads which prevent the formation of parasitic loops. The leads carrying analog signals and the leads carrying digital signals, which are interchanged (sent to the sensor or sent by the sensor) between the sensor and the substrate, may connect to two different rows in the substrate, one row of connectors (e.g. pads) for each type of signal. The leads may be adapted to connect to these pads, e.g. by forming two rows, or with one row but with extensions or feet or bent portions or the like, so that some leads connect to a pad row and others connect to the other pad row.

This configuration of the leads provides an advantageous immunity to external noise and to high frequencies on its own. Such configuration can also be combined with the differential configuration described with reference to Fig. 6 to Fig. 8, for example, where the sensing positions are distanced in the third direction. The signal output of a sensor combining both the lead layout and the layout of the sensing positions has a high immunity to external noise, and allows accurate measurement of currents with a high frequency.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used. Functionality may be added or deleted from the block diagrams and operations may be interchanged among functional blocks. Steps may be added or deleted to methods described within the scope of the present invention.

**Claims**

1. A magnetic field sensor (100) for sensing a current flowing in a first direction (Y) divided in at least two conductor portions (201, 202) separated in a second direction (X) perpendicular to the first direction (Y), the sensor comprising at least a first sensing element (101) and second sensing element (102) and at least one integrated magnetic concentrator for sensing the magnetic field at respectively first and second positions in a region between the two conductor portions, wherein the at least two sensing elements are adapted in combination with the concentrator to sense the field with a highest sensitivity in a sensing direction perpendicular to the first direction (Y), wherein the two positions are separated by a predetermined distance in a spacing direction perpendicular to the sensing direction.

2. The sensor of the previous claim wherein the at least two sensing elements are separated in the second direction (X).

3. The sensor of claim 1 wherein the at least two sensing elements are separated in the third direction (Z).

4. The sensor of claim 1 wherein the spacing direction of the two sensing positions is a first spacing direction perpendicular to the first direction (Y), and the sensor comprises at least two additional sensing elements for sensing the magnetic field at the two positions separated in a second spacing direction perpendicular to the first direction (Y) and different from the first spacing direction.

5. The sensor of claim 4, wherein the additional sensing elements combined with magnetic concentrator have the highest sensitivity in a direction perpendicular to the second spacing direction.

6. The sensor of the claim 5 wherein said direction perpendicular to the second spacing direction is the second direction (X) or the third direction (Z).

7. The sensor of any one of the previous claims comprising a substrate (300) whereon the at least two sensing elements and the concentrator are provided, wherein the substrate lies in the plane comprising the second direction (X) and third direction (Z), wherein the sensing elements provide a signal each derived from a component of the field parallel to the substrate, the sensor further comprising a processing circuit arranged to obtain a sensor signal calculated as a difference or gradient of the signals from the sensing elements.

8. The sensor of any one of the previous claims wherein the magnetic field sensor comprises a package and conductive leads (301) for interchanging signals between the exterior and the sensor, the conductive leads being elongated and extending from the package in the third direction (Z), optionally wherein the elongated leads comprise a set of leads (301) forming a single row aligned with the second directon (X).

9. The sensor of the previous claim wherein each of the elongated leads carry either an analog signal or a digital signal, wherein the elongated lead extending away from the substrate comprise an end opposite to the substrate, wherein the leads carrying analog signal are configured for redirecting the signal and connecting to a first row of connections (401), and wherein the leads carrying a digital signal are configured for redirecting the signal and connecting to a second row of connections (402) of a further device (400).

10. The sensor of any one of the claims 8 or 9 wherein all the leads of the sensor connect to the same side of the substrate.

11. The sensor of any one of the previous claims wherein the at least one sensing element comprises at least two sensing elements combined with a magnetic concentrator per position.

12. The sensor of any one of claims 1 to 10 wherein the at least one sensing element comprises at least two sensing elements per position combined with a magnetic concentrator per sensing element.

13. The sensor of any one of the previous claims wherein at least one sensing element is a horizontal Hall sensing element.

14. Use of a sensor in accordance with any one of the previous claims for detecting high frequency currents through a conductor (200) comprising a hole (203) through the conductor in which the sensor is placed.

15. A sensing system comprising a conductor (200) including a through hole (203) surrounded by conductive material, further comprising a sensor in accordance with any one of claims 1 to 13, wherein the sensor is introduced inside the through hole so that the sensing elements are arranged to sense the field in at least two positions in a region between two conductive portions of the conductor.

FIG. 1

FIG. 2

FIG. 3

FIG. 4

FIG. 5

FIG. 6

FIG. 7

FIG. 8

FIG. 9

FIG. 10

*FIG. 11*

*FIG. 12*

## FIG. 13

## FIG. 14

**Europäisches Patentamt**
**European Patent Office**
**Office européen des brevets**

# EUROPEAN SEARCH REPORT

**Application Number**

EP 24 17 4398

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/091161 A1 (HOUIS SIMON [CH]) 24 March 2022 (2022-03-24) | 1-6,8, 10-15 | INV. G01R15/20 |
| Y | * paragraph [0001] - paragraph [0146]; | 7 | |
| A | figures 1a-1f, 4g-4h * | 9 | |
| | ----- | | |
| Y | EP 3 671 228 A1 (MELEXIS TECH SA [CH]) 24 June 2020 (2020-06-24) | 7 | |
| A | * paragraph [0143]; figures 1a-1b * | 1-6,8-15 | |
| | ----- | | |
| A | US 2022/018880 A1 (HOUIS SIMON [CH]) 20 January 2022 (2022-01-20) * the whole document * | 1-15 | |
| | ----- | | |
| A | JP 2017 133942 A (ALPS ELECTRIC CO LTD) 3 August 2017 (2017-08-03) * the whole document * | 1-15 | |
| | ----- | | |

**TECHNICAL FIELDS SEARCHED (IPC)**

G01R

The present search report has been drawn up for all claims

| Place of search | Date of completion of the search | Examiner |
|---|---|---|
| Munich | 29 October 2024 | Ako, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 4398

This annex lists the patent family members relating to the patent documents cited in the above-mentioned European search report.
The members are as contained in the European Patent Office EDP file on
The European Patent Office is in no way liable for these particulars which are merely given for the purpose of information.

29-10-2024

| Patent document cited in search report | | | Publication date | Patent family member(s) | | | Publication date |
|---|---|---|---|---|---|---|---|
| US 2022091161 | A1 | | 24-03-2022 | CN | 114252677 | A | 29-03-2022 |
| | | | | EP | 3974845 | A1 | 30-03-2022 |
| | | | | US | 2022091161 | A1 | 24-03-2022 |
| | | | | US | 2024036084 | A1 | 01-02-2024 |
| EP 3671228 | A1 | | 24-06-2020 | CN | 111308153 | A | 19-06-2020 |
| | | | | DE | 102019133922 | A1 | 18-06-2020 |
| | | | | DE | 202019106894 | U1 | 05-03-2020 |
| | | | | EP | 3671228 | A1 | 24-06-2020 |
| | | | | FR | 3090120 | A1 | 19-06-2020 |
| | | | | US | 2020191835 | A1 | 18-06-2020 |
| US 2022018880 | A1 | | 20-01-2022 | CN | 113945747 | A | 18-01-2022 |
| | | | | EP | 3940396 | A1 | 19-01-2022 |
| | | | | US | 2022018880 | A1 | 20-01-2022 |
| | | | | US | 2023358789 | A1 | 09-11-2023 |
| JP 2017133942 | A | | 03-08-2017 | JP | 6671985 | B2 | 25-03-2020 |
| | | | | JP | 2017133942 | A | 03-08-2017 |

EPO FORM P0459

For more details about this annex : see Official Journal of the European Patent Office, No. 12/82